# EUROPÄISCHE PATENTSCHRIFT

(11) **EP 2 695 246 B1**
(45) Veröffentlichungstag und Bekanntmachung des Hinweises auf die Patenterteilung: **21.01.2015**
(21) Anmeldenummer: 12709835.8
(22) Anmeldetag: 12.03.2012
(51) Int. Cl.: H01R 13/52, H01R 43/00, H05K 7/02

(54) **ABDICHTUNG VON GEHÄUSEN FÜR STECKKONTAKTELEMENTE**
SEALING OF HOUSINGS FOR CONTACT ELEMENTS
ETANCHEITÉ DE BOITIERS POUR DES ELEMENTS DE CONTACT

(30) Priorität: 07.04.2011 DE 102011006928
(43) Veröffentlichungstag der Anmeldung: 12.02.2014
(73) Patentinhaber: Robert Bosch GmbH, 70442 Stuttgart (DE)
(72) Erfinder: HEINRICH, Thomas, 71254 Ditzingen (DE)
(86) Internationale Anmeldenummer: PCT/EP2012/054250
(87) Internationale Veröffentlichungsnummer: WO 2012/136446

(56) Entgegenhaltungen:
- EP-A2- 0 696 827
- FR-A1- 2 908 238
- US-A- 5 620 344
- US-A- 5 720 629

## Beschreibung

Die vorliegende Erfindung betrifft Gehäuse für Kfz-Komponenten. Insbesondere betrifft die vorliegende Erfindung ein Gehäuse für Steckkontaktelemente, ein Fahrzeug, insbesondere ein Automobil, aufweisend ein erfindungsgemäßes Gehäuse für Steckkontaktelemente, die Verwendung eines erfindungsgemäßen Gehäuses in einem Fahrzeug, insbesondere einem Automobil, sowie ein Verfahren zur Montage von Steckkontaktelementen.

### Stand der Technik

Elektronikkomponenten in einem Fahrzeug sind meist dezentral, in sich abgeschlossen, in separaten Gehäusen, an verschiedenen Stellen in einem Fahrzeug, insbesondere einem Automobil, angeordnet. Die einzelnen Elektronikkomponenten sind elektrisch untereinander verbunden unter Verwendung von sogenannten Kabelbäumen, welche mittels Stecker am Kabelbaum an Buchsen an der Elektronikkomponente angeschlossen sind.

Ein Kabelbaum wird fahrzeugspezifisch in einer vorgegebenen Form aus einzelnen Kabeln bzw. Leitern aufgebaut bzw. gefertigt. An entsprechenden Positionen im Kabelbaum werden die einzelnen Leiter des Kabelbaumes gebündelt und in ein Steckergehäuse eingebracht, um somit den Anschluss einer Elektronikkomponente an den Kabelbaum zu ermöglichen.

Hierbei werden die Leiter des Kabelbaumes einzeln abisoliert und meist mit einem Kontaktelement versehen, welches beispielsweise an das einzelne Kabel angecrimpt wird. Eine Mehrzahl der mit Kontaktelementen bestückten Leiter wird nachfolgend in ein Gehäuse bzw. Steckergehäuse eingebracht, welches somit unter Verwendung der Kontaktelemente den Stecker selbst aufzubauen vermag.

Ein Steckergehäuse bildet so im Wesentlichen eine definierte Aufnahmemöglichkeit bzw. Beabstandung einzelner Kontaktelemente aus und ergibt hierdurch das Steckerelement.

Hierbei mag es im Weiteren notwendig sein, die einzelnen Kontaktelemente im Steckergehäuse derart zu fixieren, dass ein Entfernen eines Kontaktelementes nicht oder nur unter erschwerten Bedingungen möglich ist. Kontaktelemente mögen mit einer Arretierung im Steckerelement verankert sein oder aber mögen gleichfalls in einzelnen Aufnahmeöffnungen für Kontaktelemente befestigt sein.

Herkömmliche Steckergehäuse bzw. Gehäuse für Steckkontaktelemente mögen vorab montierte, zum Beispiel gelförmige oder feste, Abdichtungen aufweisen. Diese mögen jedoch durch eine scharfkantige Form eines Crimps oder des Kontaktelementes selbst im Rahmen der Montage der Kontaktelemente im Gehäuse beschädigt werden, wodurch möglichweise nachfolgend Undichtigkeiten des Steckers resultieren.

US 5 720 629 offenbart ein Gehäuse für Steckkontaktelemente nach dem Oberbegriff des Anspruchs 1.

### Offenbarung der Erfindung

Ein Aspekt der vorliegenden Erfindung mag somit in der Bereitstellung einer verbesserten Dichtigkeit bzw. Abdichtung von einzelnen Kontaktelementen in einem Steckergehäuse gesehen werden.

Im Lichte dieses Aspekts wird ein Gehäuse für Steckkontaktelemente, ein Fahrzeug aufweisend ein erfindungsgemäßes Gehäuse, ein Verfahren zur Montage von Steckkontaktelementen in einem Gehäuse sowie die Verwendung eines erfindungsgemäßen Gehäuses in einem Fahrzeug gemäß der unabhängigen Ansprüche bereitgestellt. Bevorzugte Ausgestaltungen ergeben sich aus den abhängigen Ansprüchen.

Eine erfindungsgemäße Abdichtung eines Steckkontaktelementes in einem Gehäuse mag somit erst nach dem Bestücken eines Gehäuses mit einem Steckkontaktelement erfolgen. Insbesondere mag die Abdichtung erst nach dem Bestücken eines Steckkontaktelementes in einer Aufnahmeöffnung, welche eingerichtet ist, das Steckkontaktelement im Steckergehäuse definiert aufzunehmen und auszurichten, erfolgen. Das Steckkontaktelement mag hierbei in die Aufnahmeöffnung des Gehäuses eingebracht werden. Je nach Ausgestaltung des Steckkontaktelementes und der Aufnahmeöffnung mag sich im Weiteren jedoch ein Hohlraum ergeben, so dass das Steckkontaktelement nicht bzw. zumindest mit seinem Crimpbereich nicht derart dichtend im Steckergehäuse verankert ist, so dass, beispielsweise von außerhalb, von der Kabelseite bzw. vom Kabelbaum her gesehen, eine Dichtigkeit gegenüber Feuchtigkeit bereitgestellt bzw. sichergestellt ist. Eine solche Dichtigkeit mag jedoch gefordert sein, da sonst beispielsweise in einem Fall, in dem von außen, von der Seite des Kabelbaumes her gesehen, eine Flüssigkeit auf das erfindungsgemäße Steckergehäuse aufgebracht wird, diese Flüssigkeit beispielsweise alle oder zumindest einen Teil der Steckkontaktelemente elektrisch leitfähig verbinden, somit kurzschließen vermag.

In diesem Zusammenhang mag das Gehäuse der Elektronikkomponente im Fahrzeug selbst im Wesentlichen feuchtigkeitsdicht ausgebildet sein, ebenso eine Buchse, angebracht am Gehäuse. Im aufgesteckten Zustand eines erfindungsgemäßen Steckergehäuses für Steckkontaktelemente, angebracht am Kabelbaum, auf der Buchse eines Gehäuses einer Elektronikkomponente mag, abgesehen von der Seite, von welcher die einzelnen Kabellitzen aus dem Kabelbaum in den Stecker eingebracht werden, eine im Wesentlichen hermetische Abdichtung von Stecker, Buchse und Gehäuse bereitgestellt sein.

Somit mag als einzige Schwachstelle eines Steckergehäuses die Richtung gesehen werden, aus welcher die einzelnen Kabellitzen in das Steckergehäuse eingebracht werden, somit aus Richtung des Kabelbaums.

Die vorliegende Erfindung ermöglicht das Bereitstellen einer Abdichtung derjenigen Seite eines Steckergehäuses, welche in Richtung des Kabelbaumes ausgerichtet ist.

So soll hierdurch eine Abdichtung der einzelnen Steckkontaktelemente nach außen, in Richtung des Kabelbaumes, bereitgestellt werden. In dem Moment, in dem die Abdichtung derart ausgebildet wird, dass ausschließlich das isolierte Kabel bzw. die einzelnen isolierten Kabellitzen bzw. Leiter aus der Dichtung heraus und somit aus dem Steckergehäuse heraus ragen, mag eine entsprechende Dichtung als realisiert angenommen werden.

Gemäß der vorliegenden Erfindung erfolgt somit die Abdichtung nach dem Bestücken des Steckergehäuses mit Steckkontaktelementen derart, dass ein Dichtmaterial in die einzelnen Hohlräume, welche sich um die Steckkontaktelemente herum bzw. im Zwischenraum zwischen den Steckkontaktelementen und dem Gehäuse des Steckers ergeben, mit Dichtmaterial aufgefüllt werden.

Erfindungsgemäß wird hierbei beispielsweise ein selbstquellendes bzw. durch Luft oder Feuchtigkeit quellendes Material verwendet, welches beispielsweise in die Hohlräume eingespritzt wird und nachfolgend formflexibel und formschlüssig eine Dichtung jedes einzelnen Steckkontaktelementes zu seinem umgebenden Gehäusebereich des Gehäusesteckers bereitstellen mag. Auch ist denkbar, dass beispielsweise ein Dichtmaterial verwendet wird, welches über ein Aktivatormaterial aufquillt bzw. aushärtet, um die formflexible und formschlüssige Dichtung bereitzustellen, oder aber beispielsweise auch durch aufgebrachte Strahlung in seinen dichtenden Zustand übergeführt wird. Eine Volumenvergrößerung, somit ein Selbstquellen des Dichtmaterials, mag hierbei eine besonders bevorzugte Abdichtung ermöglichen.

Um eine einfache Abdichtung von möglicherweise einer Vielzahl von Aufnahmeöffnungen mit Steckkontaktelementen in einem Gehäusestecker vorzunehmen, mag erfindungsgemäß das Dichtmaterial an einigen wenigen oder auch nur einer Stelle zentral oder abschnittsweise zentral in das Steckergehäuse eingebracht werden. Hierfür mag das Steckergehäuse zumindest eine erste Öffnung zum Einbringen eines fließfähigen Dichtmaterials aufweisen. Unter Verwendung dieser Öffnung mag das Dichtmaterial in das Gehäuse eingebracht werden, beispielsweise eingespritzt werden.

Ausgehend von der zumindest einen ersten Öffnung mag im Inneren des Steckergehäuses ein Kanalelement angeordnet sein, welches die zumindest eine erste Öffnung mit den einzelnen Aufnahmeöffnungen der Steckkontaktelemente verbindet. Hierdurch wird es ermöglicht, das zunächst fließfähige Dichtmaterial über die zumindest eine erste Öffnung in das Steckergehäuse einzuspritzen, wodurch das fließfähige Dichtmaterial unter Verwendung des Kanalelementes im Steckergehäuse verteilt wird und in jede mit dem Kanalelement verbundene Aufnahmeöffnung einfließt.

Beim Einfließen des Dichtmaterials in die einzelnen Aufnahmeöffnungen mag insbesondere ein in der Aufnahmeöffnung angeordnetes Steckkontaktelement umflossen und somit vollständig vom Dichtmaterial umgeben werden. Somit mag unter Verwendung der zumindest einen ersten Öffnung das fließfähige Dichtmaterial in die Aufnahmeöffnungen des Steckergehäuses eingebracht werden, sämtliche Steckkontaktelemente umschließen, um im Nachfolgenden formflexibel und formschlüssig auszuhärten, beispielsweise aufzuquellen.

Das Aufquellen mag hierbei durch Luft oder Feuchtigkeit ausgelöst sein, durch die Verwendung eines Aktivatormaterials, durch Verwendung einer Strahlung oder einfach selbstquellend in Bezug auf eine bestimmte Zeitkonstante sein.

Ein bevorzugtes Einfließen von Dichtmaterial in die Aufnahmeöffnungen mag sich bei herkömmlichen Steckergehäusen bei Direktsteckverbindungen dadurch ergeben, dass diese Steckergehäuse meist relativ schmal und gleichzeitig relativ breit ausgebildet sind, so dass die auszufüllende Form der Aufnahmeöffnung um das Steckkontaktelement herum sehr einfach bzw. relativ einfach ausgebildet ist. Es mögen somit wenig Hinterschneidungen auftreten, meist runde Formen vorhanden sein und unabhängig von der Länge des Gehäusesteckers eine immer gleiche bzw. sich wiederholende Geometrie realisiert sein.

Nach Bestücken des Steckergehäuses mit den einzelnen Steckkontaktelementen wird das fließfähige Dichtmaterial eingespritzt. Nach Aushärtung bzw. Aufquellen des Dichtmaterials mag sich das Gehäuse mit den aufgenommenen Steckkontaktelementen im Wesentlichen als ein einstückiges Bauteil darstellen.

Ausführungsbeispiele der Erfindung sind in den Zeichnungen dargestellt und in der nachfolgenden Beschreibung näher erläutert.

Es zeigen
Fig. 1 eine schematische Darstellung eines exemplarischen Ausführungsbeispiels eines Gehäuses für Steckkontaktelemente gemäß der vorliegenden Erfindung in Draufsicht;
Fig. 2 eine schematische Darstellung eines Kombinationsquerschnittes eines exemplarischen Ausführungsbeispiels eines Gehäuses für Steckkontaktelemente gemäß der vorliegenden Erfindung; und
Fig. 3 bis 6 schematische Darstellungen weiterer exemplarischer Ausgestaltungen eines Gehäuses für Steckkontaktelemente gemäß der vorliegenden Erfindung in Draufsicht.

### Ausführungsformen der Erfindung

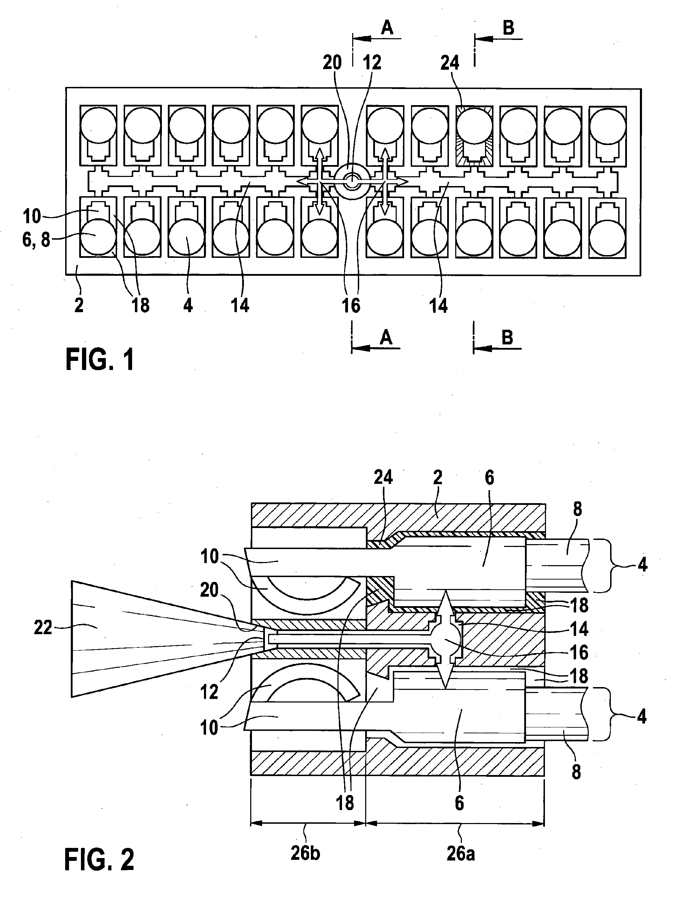

Fig. 1 zeigt exemplarisch einen Gehäusestecker der vorliegenden Erfindung mit von vorderseitig zentral an einer Stelle eintretenden ersten Öffnung 12. Die mittige Position des Einspritzpunktes ist nicht zwingend, sondern mag unter anderem von der Bestückung, kleine Kontaktelemente, große Powerkontaktelemente, unbestückte Aufnahmeöffnungen bzw. Leerkammern und Mischbestückung abhängen.

Gehäuse 2 weist zentral Einspritzpunkt auf, welcher derart eingerichtet ist um, ein fließfähiges Dichtmaterial in das Gehäuse einzubringen. Angeschlossen an Einspritzpunkt st Kanalelement 14 bzw. Flusskanal welcher im Weiteren ausgehend vom Einspritzpunkt das Gehäuse 2 durchläuft und den Einspritzpunkt für ein Dichtmaterial fließfähig mit den einzelnen Aufnahmeöffnungen 18 bzw. Hohlräumen verbindet.

Nur schematisch eingezeichnete Luftauslässe bzw. Verbindungen zwischen Hohlraum und Flusskanal 14 ermöglichen ein über Einspritzpunkt eingebrachtes Dichtmaterial derart im Gehäuse zu verteilen, so dass dieses über Flusskanal 14 in die einzelnen Hohlräume des Gehäuses 2 fließt bzw. eintritt und die dort angeordneten Steckkontakte 4 umfließt. Durch das Umfließen der Steckkontakte 4 in den Hohlräumen 18 mögen diese im Wesentlichen vollständig von fließfähigem Dichtmaterial umschlossen werden.

Eine entsprechende Flussrichtung 16 bzw. ein Materialfluss 16 ist in Fig. 1 mit Richtungspfeilen dargestellt. Die einzelnen Steckkontaktelemente bestehen hierbei aus einem Crimp bzw. Crimpbereich 6, welcher auf ein Kabel 8 aufgecrimpt wurde. An Crimpbereich 6 angeschlossen ist Federelement 10, um im Zusammenspiel mit einer Gehäusebuchse eine sichere elektrisch leitfähige Verbindung bereitzustellen.

Fließfähiges Dichtmaterial wird somit über Einspritzpunkt in den Flusskanal 14 eingebracht und über diesen im Gehäuse 2 verteilt, bis im Wesentlichen sämtliche Hohlräume um die einzelnen Steckkontaktelemente 4 aufgefüllt sind. Eingespritztes Dichtmaterial 24 um die Steckkontaktelemente 4 ist in Fig. 1 schematisch in einem Hohlraum dargestellt. Nachdem das fließfähige Dichtmaterial im Wesentlichen vollständig in das Gehäuse 2 bzw. Hohlräume um Steckkontaktelemente 4 herum eingebracht wurde, mag dieses die Dichtigkeit durch Aufquellen bzw. formflexibles und formschlüssiges Aushärten bereitstellen. Das Quellen mag hierbei aufgrund einer Verarbeitungszeit, aufgrund von Luft bzw. Feuchtigkeit, aufgrund eines Aktivators oder aufgrund Strahlung erfolgen.

Weiter Bezug nehmend auf Fig. 2, wird eine schematische Darstellung eines Kombinationsquerschnittes eines exemplarischen Ausführungsbeispiels eines Gehäuses für Steckkontaktelemente gemäß der vorliegenden Erfindung dargestellt.

Fig. 2 ist hierbei eine Kombinationsschnittzeichnung durch die Ebenen A und B. Die einzelnen Steckkontaktelemente 4 werden durch Schnittebene B dargestellt, während Einspritzpunkt gemäß Schnittebene A dargestellt wird. Exemplarisch in Fig. 2 sind zwei übereinanderliegende Kontaktelementreihen im Gehäuse 2 angeordnet.

Die Steckkontaktelemente 4 weisen einen Crimpbereich 6 auf, in welchem sie an ein Kabel 8, beispielsweise eines Kabelbaumes angeschlossen sind. Crimpbereiche 6, z.B. ausgebildet aus Metall, stellen hierbei eine leitfähige Verbindung mit der Litze im Kabel 8 dar und ermöglichen somit ein elektrisch leitfähiges Anschließen einer Buchse über die Federelemente 10. Die Federelemente 10 sind hierbei flexibel ausgestaltet, um einen sicheren elektrisch leitfähigen Kontakt mit den komplementären Buchsenelementen bereitzustellen.

Über eine nur schematisch dargestellte Spritze 22 wird fließfähiges Dichtmaterial gemäß Materialfluss 16 in das Innere des Gehäuses 2 eingebracht. Spritze 22 und Einspritzpunkt mögen hierbei derart ausgebildet sein, eine Zentrierung und Abdichtung 20 zwischen Spritze 22 und Einspritzpunkt bereitzustellen. Beispielsweise mögen sowohl Spritze 22 als auch Einspritzpunkt konisch verjüngend ausgebildet und derart aufeinander angepasst sein, so dass die eingebrachte Spritze 22 in Einspritzpunkt automatisch zentriert und abgedichtet wird. Hierdurch wird ermöglicht, dass eingebrachtes fließfähiges Dichtmaterial im Wesentlichen ausschließlich in den Flusskanal 14 eingebracht und im Gehäuse 2 gemäß Materialfluss 16 verteilt wird.

Im oberen Hohlraum des dargestellten Gehäuses 2 ist, der Übersichtlichkeit halber nur dort, eingespritztes Dichtmaterial 24 abgebildet. Über Flusskanal 14 wird hierbei eingebrachtes Dichtmaterial 24 im Wesentlichen im ersten Teil 26a des Hohlraumes angeordnet bzw. eingespritzt. So erfolgt einerseits eine Isolierung bzw. Abdichtung des Crimpbereichs 6 gegenüber dem Kabel 8 bzw. der Außenseite des Gehäuses 2 in Richtung des Kabelbaumes und somit in Richtung der Kabel 8, während gleichzeitig die Federelemente 10 nicht von Dichtmaterial umgeben sind und somit einen bevorzugten elektrisch leitfähigen Kontakt mit komplementären Gehäusebuchsen an einer Elektronikkomponente bereitstellen mögen.

Wenn nun sämtliche Hohlräume in ihrem Bereich 26a und nicht im zweiten Bereich 26b mit Dichtmaterial ausgefüllt sind, welches nachfolgend formschlüssig und formflexibel den ersten Bereich 26a aller Hohlräume auszufüllen vermag, wird die Innenseite des Gehäuses im zweiten Bereich 26b, an den Federelementen 10, gegenüber Außenseite des Gehäuses in Richtung Kabelbaum und Kabel 8 abgedichtet bzw. isoliert. Ein entsprechendes Abdichten bzw. Eingießen der Crimpbereiche 6 der Steckkontaktelemente mag gleichzeitig die einzelnen Steckkontaktelemente im Steckergehäuse fixieren und somit ein im Wesentlichen einstückig ausgebildetes Gehäuse ergeben.

Dadurch, dass zumindest über den zweiten Bereich 26b die Hohlräume über einen Luftauslass verfügen, ist ein erfindungsgemäßes Einspritzen des fließfähigen Dichtmaterials problemlos möglich, so dass die Hohlräume im Bereich 26a aufgefüllt werden.

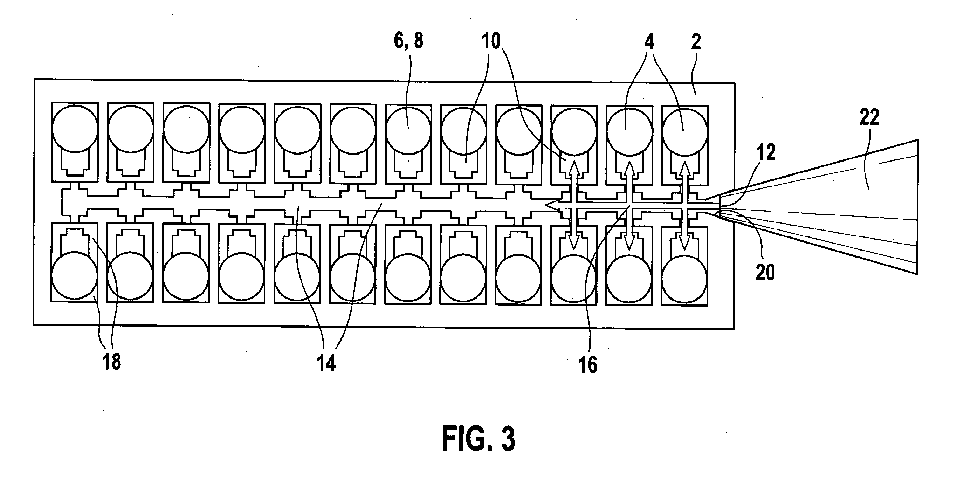

Weiter Bezug nehmend auf Fig. 3 wird eine schematische Darstellung einer weiterer exemplarischer Ausgestaltungen eines Gehäuses für Steckkontaktelemente gemäß der vorliegenden Erfindung in Draufsicht dargestellt.

Fig. 3 entspricht hierbei im Wesentlichen dem Gehäuse 2 gemäß Fig. 1, wobei in Fig. 3 das fließfähige Dichtmaterial von einer Seite längs durch den ganzen Stecker hindurch eingebracht wird. Dies erfordert eine entsprechend geänderte Ausgestaltung des Flusskanals 14, welcher trotzdem gleichfalls über einen Luftauslass mit jedem der Hohlräume verbunden ist, so dass über erste Öffnung 12 unter Verwendung von Spritze 22 ein Materialfluss 16 von fließfähigem Dichtmaterial bereitgestellt werden mag, so dass dieses in die Hohlräume einfließt und die dort angeordneten Steckkontakte 4 erfindungsgemäß umschließt.

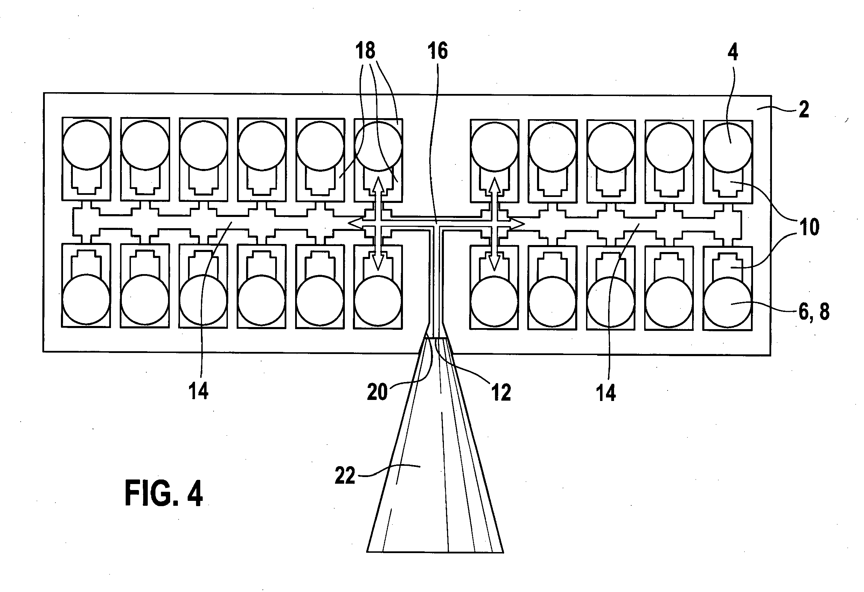

Weiter Bezug nehmend auf Fig. 4 wird eine schematische Darstellung einer weiterer exemplarischer Ausgestaltungen eines Gehäuses für Steckkontaktelemente gemäß der vorliegenden Erfindung in Draufsicht dargestellt.

Gemäß Fig. 4 entspricht Gehäuse 2 der Ausgestaltung von Gehäuse 2 gemäß Fig. 1, wobei hierbei die erste Öffnung 12 bzw. der Einspritzpunkt nicht mittig auf der Steckerseite, bezogen auf eine Steckrichtung in Richtung einer Elektronikkomponente in einem Fahrzeug, bezogen erfolgt, sondern von oben bzw. unten und hierbei mittig quer zur Ausrichtung des Flusskanals 14 an einer Stelle erfolgt.

Die mittige Position des Anspritzpunktes bzw. Einspritzpunktes 12 ist nicht zwingend, sondern mag unter anderem von der Bestückung der Hohlräumen bzw. Aufnahmeöffnungen 18 mit Steckkontaktelementen abhängig sein. Beispielsweise mögen kleine Signalkontaktelemente, große Powerkontaktelemente, unbestückte Leerkammern oder eine beliebige Mischbestückung vorhanden sein.

Bestückung mit Steckkontaktelementen 4 sowie Einbringen von fließfähigem Dichtmaterial gemäß Materialfluss 16 über Flusskanal 14 in Hohlräume stellt sich dar wie zuvor dargelegt.

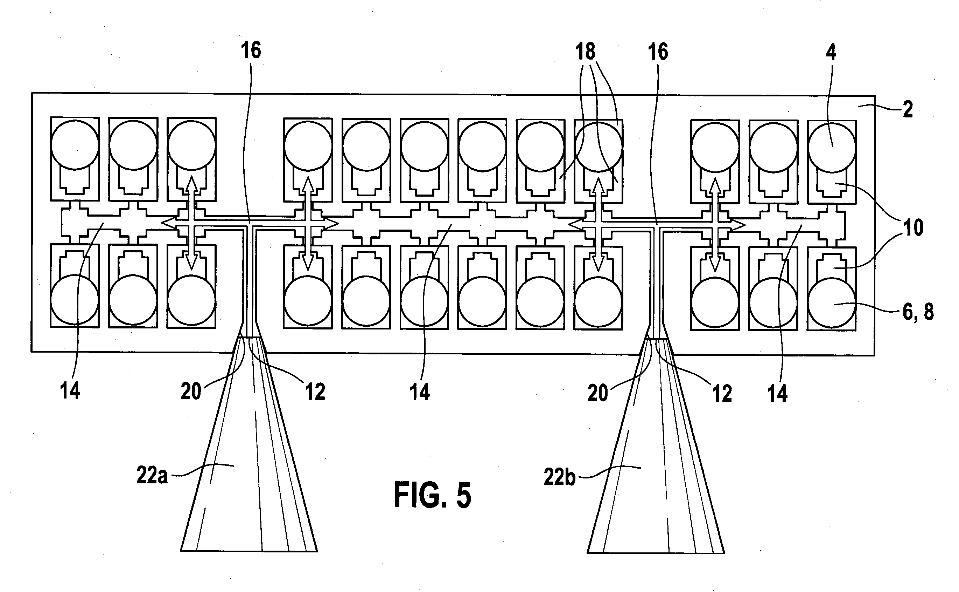

Weiter Bezug nehmend auf Fig. 5, wird eine schematische Darstellung einer weiterer exemplarischer Ausgestaltungen eines Gehäuses für Steckkontaktelemente gemäß der vorliegenden Erfindung in Draufsicht dargestellt.

Hierbei entspricht Gehäuse 2 gemäß Fig. 5 im Wesentlichen dem Gehäuse 2 gemäß Fig. 4, wobei eine Mehrzahl von Einspritzpunkten 12 bereitgestellt ist, so dass unter Verwendung von mehreren Spritzen 22a,b im Wesentlichen zeitgleich Dichtmaterial gemäß Materialfluss 16 über Flusskanal 14 in Hohlräume eingespritzt werden mag. In Fig. 5 wird somit fließfähiges Dichtmaterial von oben bzw. unten quer an mehreren Stellen in das Gehäuse 2 eingespritzt. Auch hier mag die Anordnung der Einspritzpunkte wiederum von einer gewünschten Bestückung des Steckers bzw. des Gehäuses 2 abhängig sein.

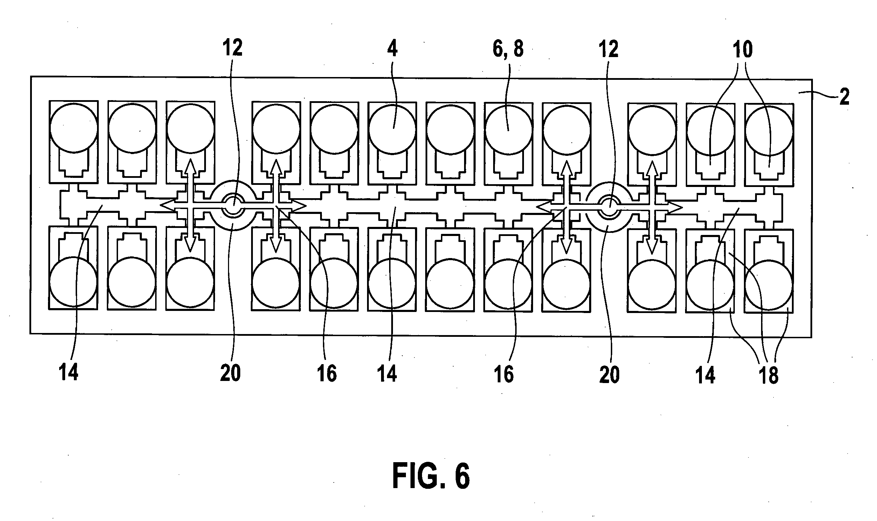

Weiter Bezug nehmend auf Fig. 6, wird eine schematische Darstellung einer weiterer exemplarischer Ausgestaltungen eines Gehäuses für Steckkontaktelemente gemäß der vorliegenden Erfindung in Draufsicht dargestellt.

Fig. 6 entspricht hierbei im Wesentlichen dem Gehäuse gemäß Fig. 1, wobei Einspritzpunkte nicht von vorne bzw. hinten an einer Stelle angeordnet sind, sondern an einer Mehrzahl von Stellen.

Somit weist Gehäuse 2 eine Mehrzahl von an verschiedenen Stellen angeordneten Einspritzpunkten auf.

## Patentansprüche

1. Gehäuse (2) für Steckkontaktelemente (4), aufweisend
zumindest eine Aufnahmeöffnung (18) für ein Steckkontaktelement (4);
**dadurch gekennzeichnet, dass**
das Gehäuse (2) zumindest eine erste Öffnung (12) zum Einbringen eines fließfähigen Dichtmaterials aufweist;
das Gehäuse (2) ein Kanalelement (14) aufweist, welches die zumindest eine erste Öffnung (12) und die Aufnahmeöffnung (18) flussfähig verbindet; und
dass ein Dichtmaterial unter Verwendung der ersten Öffnung (12) in das Kanalelement (14) einbringbar ist, so dass das Dichtmaterial unter Verwendung des Kanalelementes (14) in die Aufnahmeöffnung (18) einbringbar ist.

2. Gehäuse gemäß Anspruch 1,
wobei das Dichtmaterial ein Material ist aus der Gruppe bestehend aus selbstquellendes Dichtmaterial, durch Luft quellendes Dichtmaterial, durch Feuchtigkeit quellendes Dichtmaterial, durch ein Aktivatormaterial quellendes Dichtmaterial und ein Polyurethan-Weichintegralschaum, insbesondere als Elastomer im Formed-In-Place-Foam-Gasket (FIPFG)-Verfahren.

3. Gehäuse gemäß Anspruch 1 oder 2,
wobei das Dichtmaterial in der Aufnahmeöffnung (18) eine luftdichte, fluiddichte und/oder flüssigkeitsdichte Abdichtung der Aufnahmeöffnung (18) bereitstellt.

4. Gehäuse gemäß Anspruch 3,
wobei die Abdichtung der Aufnahmeöffnung (18) eine Abdichtung eines Steckkontaktelementes (4) in der Aufnahmeöffnung (18) bereitstellt.

5. Gehäuse gemäß einem der Ansprüche 1 bis 4.
wobei die zumindest eine erste Öffnung (12) derart ausgebildet ist eine Zentrierung und/oder Abdichtung für ein Spritzelement (22a,b) zum Einspritzen des Dichtmaterials bereitzustellen, insbesondere konisch zulaufend ausgebildet ist.

6. Gehäuse gemäß einem der Ansprüche 1 bis 5,
wobei das Steckkontaktelement (4) ausgebildet ist als ein Kabelelement (8) mit einem aufgecrimpten (6) Kontaktelement (10).

7. Gehäuse gemäß einem der Ansprüche 1 bis 6,
wobei das Gehäuse (2) eine Mehrzahl von Aufnahmeöffnungen (18) aufweist, wobei die Öffnung (12) im Gehäuse symmetrisch zu einem von Kanalelement (14) und Mehrzahl von Aufnahmeöffnungen (18) angeordnet ist; und/oder
wobei das Gehäuse (2) eine Mehrzahl von Öffnungen (12) aufweist.

8. Fahrzeug, aufweisend ein Gehäuse gemäß einem der vorhergehenden Ansprüche.

9. Verwendung eines Gehäuses gemäß einem der vorhergehenden Ansprüche in einem Automobil.

10. Verfahren zur Montage von Steckelementen, aufweisend den Schritt Einbringen eines Steckkontaktelementes (4) in eine Aufnahmeöffnung (18) eines Gehäuses (2) für Steckkontaktelemente;
**gekennzeichnet durch** den Schritt
Einbringen eines fließfähigen Dichtmaterials in die Aufnahmeöffnung (18), zum Abdichten der Aufnahmeöffnung (18).

## Claims

1. Housing (2) for plug-in contact elements (4), having
at least one receiving opening (18) for a plug-in contact element (4),
**characterized in that**
the housing (2) has at least one first opening (12) for introducing a free-flowing sealing material; the housing (2) has a channel element (14), which connects the at least one first opening (12) and the receiving opening (18) in terms of flow; and
a sealing material can be introduced into the channel element (14) using the first opening (12) such that the sealing material can be introduced into the receiving opening (18) using the channel element (14).

2. Housing according to Claim 1,
the sealing material being a material from the group consisting of self-swelling sealing material, sealing material swelling under the effect of air, sealing material swelling under the effect of moisture, sealing material swelling under the effect of an activator material and a flexible polyurethane integral foam, in particular as an elastomer of the formed-in-place-foam-gasket (FIPFG) method.

3. Housing according to Claim 1 or 2,
the sealing material in the receiving opening (18) providing an airtight, fluidtight and/or liquidtight sealing of the receiving opening (18).

4. Housing according to Claim 3,
the sealing of the receiving opening (18) providing a sealing of a plug-in contact element (4) in the receiving opening (18).

5. Housing according to one of Claims 1 to 4,
the at least one first opening (12) being formed in such a way as to provide centring and/or sealing for an injecting element (22a,b) for injecting the sealing material, in particular being formed as conically tapering.

6. Housing according to one of Claims 1 to 5,
the plug-in contact element (4) being formed as a cable element (8) with a crimped-on (6) contact element (10).

7. Housing according to one of Claims 1 to 6,
the housing (2) having a plurality of receiving openings (18), the opening (12) in the housing being arranged symmetrically in relation to the channel element (14) and the plurality of receiving openings (18); and/or
the housing (2) having a plurality of openings (12).

8. Vehicle, having a housing according to one of the preceding claims.

9. Use of a housing according to one of the preceding claims in an automobile.

10. Method for mounting plug-in elements, comprising the step of
introducing a plug-in contact element (4) into a receiving opening (18) of a housing (2) for plug-in contact elements;
**characterized by** the step of
introducing a free-flowing sealing material into the receiving opening (18), for sealing the receiving opening (18).

## Revendications

1. Boîtier (2) pour des éléments de contact enfichables (4), présentant au moins une ouverture de réception (18) pour un élément de contact enfichable (4) ;
**caractérisé en ce que**
le boîtier (2) présente au moins une première ouverture (12) pour l'introduction d'un matériau d'étanchéité coulant ;
le boîtier (2) présente un élément de canal (14) qui relie fluidiquement l'au moins une première ouverture (12) et l'ouverture de réception (18) ; et
un matériau d'étanchéité peut être introduit dans l'élément de canal (14) en utilisant la première ouverture (12), de telle sorte que le matériau d'étanchéité puisse être introduit dans l'ouverture de réception (18) en utilisant l'élément de canal (14).

2. Boîtier selon la revendication 1,
dans lequel le matériau d'étanchéité est un matériau du groupe constitué de matériau d'étanchéité autogonflant, de matériau d'étanchéité gonflant à l'air, de matériau d'étanchéité gonflant à l'humidité, de matériau d'étanchéité gonflant sous l'effet d'un matériau activateur, et d'une mousse souple intégrale en polyuréthane, en particulier sous forme d'élastomère dans un procédé FIPFG (Formed-in-Place-Foam-Gasket).

3. Boîtier selon la revendication 1 ou 2,
dans lequel le matériau d'étanchéité dans l'ouverture de réception (18) fournit une étanchéité de l'ouverture de réception (18) étanche à l'air, aux fluides et/ou aux liquides.

4. Boîtier selon la revendication 3,
dans lequel le joint d'étanchéité de l'ouverture de réception (18) assure l'étanchéité d'un élément de contact enfichable (4) dans l'ouverture de réception (18).

5. Boîtier selon l'une quelconque des revendications 1 à 4,
dans lequel l'au moins une première ouverture (12) est réalisée de manière à fournir un centrage et/ou une étanchéité pour un élément d'injection (22a, b) pour injecter le matériau d'étanchéité, en particulier est réalisée de manière à se rétrécir coniquement.

6. Boîtier selon l'une quelconque des revendications 1 à 5,
dans lequel l'élément de contact enfichable (4) est réalisé sous forme d'élément de câble (8) avec un élément de contact (10) appliqué par sertissage (6).

7. Boîtier selon l'une quelconque des revendications 1 à 6,
dans lequel le boîtier (2) présente une pluralité d'ouvertures de réception (18), l'ouverture (12) étant disposée dans le boîtier symétriquement par rapport à l'élément de canal (14) et la pluralité d'ouvertures de réception (18) ; et/ou dans lequel le boîtier (2) présente une pluralité d'ouvertures (12).

8. Véhicule présentant un boîtier selon l'une quelconque des revendications précédentes.

9. Utilisation d'un boîtier selon l'une quelconque des revendications précédentes dans une automobile.

10. Procédé de montage d'éléments enfichables, présentant l'étape d'introduction d'un élément de contact enfichable (4) dans une ouverture de réception (18) d'un boîtier (2) pour des éléments de contact enfichables ;
**caractérisé par** l'étape
d'introduction d'un matériau d'étanchéité coulant dans l'ouverture de réception (18), pour réaliser l'étanchéité de l'ouverture de réception (18).
